# EUROPEAN PATENT SPECIFICATION

(11) **EP 1 357 632 B1**
(45) Date of publication and mention of the grant of the patent: **18.02.2009**
(21) Application number: 02252832.7
(22) Date of filing: 23.04.2002
(51) Int. Cl.: H01P 3/08

(54) **Method to suppress disturbances in multilayer-multiconductor microstrip**
Verfahren zur Unterdrückung von Störungen in mehrlagigen Mikrostreifenleitungen mit mehreren Leitern
Méthode pour supprimer les perturbations dans un microruban de type multicouche avec multiconducteur

(43) Date of publication of application: 29.10.2003
(73) Proprietor: LUCENT TECHNOLOGIES INC., Murray Hill NJ 07974-0636 (US)
(72) Inventor: Hocke, Ralf, Erlangen, By 91056 (DE); Schmauss, Bernhard, Theisseil 92637 (DE); Ziegler, Christof, Bamberg, By 96052 (DE)
(74) Representative: Sarup, David Alexander

(56) References cited:
- US-A- 4 383 227
- US-A- 5 045 819

## Description

### Technical Field

The invention relates to a method for suppressing disturbances during transmission on symmetrically operated high-frequency lines and to dispositions having such functionality.

### Background of the Invention

In general, coupled lines and/or coupled planar transmission lines, are, owing to their properties, suitable for deployment in digital transmission systems. Based thereon, in the three-wire systems having two signal lines and a ground line, two operating conditions exist respectively resulting in two basic modes, the even mode and the odd mode.

In the even mode, both signal lines have the same potential with respect to ground.

In the odd mode, the signal lines, however, possess potentials of the same magnitude with respect to ground but with opposing signs. Provided the lines are laid closely enough together, external electromagnetic fields will, to a first approximation, have the same effect on both of the signal lines. For this reason, the influence of interfering electromagnetic fields is therefore the same for each of the lines which is the reason why, in the case of the odd mode, interference is very well compensated, and the information carried is not affected.

The odd mode is used for the data transmission, i.e. two signals are generated with equal magnitude but with a 180° phase difference and transmitted on the symmetrically operated line. At the receiver the potential difference between the two lines is measured and interpreted as the signal. Interference which is influenced on both signal lines equally is, therefore, suppressed in this signal transmission mode.

Although an even mode signal wave transmitted on the symmetrically operated line is not detected at the receiver due to the measured potential difference resulting in a zero signal, after a reflection of the even mode signal wave at the receiver for example, an asymmetry may convert this even mode wave into an odd mode wave, which then interferes with the desired odd mode wave which transmits the desired signal. The signal distortion caused thereby leads to a deterioration in the signal, which, in the case of transmission of digital signals, will lead to inter-symbol interference resulting in a reduced eye-opening in the eye-diagram.

Furthermore, multiple reflections caused for example by irregularities on the line and/or an asymmetrical line layout usually result in an unavoidable coupling of the two modes. An asymmetrical line layout arise for example from curves in the lines which result in different geometrical line lengths.

As mentioned above, in the case of the odd mode, the phase difference Δϕ between the electrical potentials on both lines should be exactly Δϕ = 180°. If, for example, as the result of a length difference between the lines, the phase difference Δϕ is changed, a mixed mode is the result having an additional component in the even mode. The phase velocity and line impedance for the even mode and the odd mode however, differ greatly in the case of strong coupled lines and hence, there is a bad matching for the even mode. As a consequence, there is an increased reflection of the even mode component, which in turn has a further detrimental effect on the signal quality and therefore on the transmission behavior.

Moreover, applications using coupled lines are common for frequencies up to several GHz. If the range of application extends to higher frequencies, however, it becomes more and more difficult to realize low-reflecting junctions and low-reflecting connections. Thus, in low-loss lines, multiple reflections occur at such discontinuities or irregularities, which leads to a coupling of the two modes in the same way as an asymmetrical line layout. In this regard, a further disadvantage relates to the current way of ensuring that the lines are strictly symmetrical. For frequencies in the microwave region up to 100 GHz, the wavelength on commonly used substrate materials is approximately 1 mm to 6 mm. Therefore even a small difference in length between the two lines will cause a large phase difference Δϕ.

### Summary of the Invention

An object of the invention is therefore, to provide with regard to the prior art a new and improved approach for suppressing disturbances during transmission on symmetrically operated high-frequency lines, in particular to suppress the even mode accordingly.

The inventive solution of the object is achieved by a method incorporating the features of claim 1 and/or by a disposition incorporating the features of claim 4.

A disposition according to the preamble of claim 4 is known from patent document US-A-4 383 227.

Advantageous and/or preferred embodiments or refinements are the subject matter of the respective dependent claims.

Accordingly, the invention proposes to suppress disturbances during transmission on symmetrically operated high-frequency lines by providing a field jamming source, in particular a source hindering or affecting an electromagnetic field, within an area, which is influenced mainly by the magnetic and/or electric field caused by the even mode, for the selective attenuation of the even mode. Correspondingly, by using a disposition comprising at least two ground balanced lines adapted to be used for a symmetrical high-frequency operation, wherein a field jamming material, in particular a material hindering or affecting an electromagnetic field, is incorporated within such an influenced area an increased attenuation of the even mode compared to the odd mode is achieved. In particular for planar coupled lines, it is possible to suppress the proportion of even mode by attenuating while the odd mode is not or if the worst comes to the worst minimally affected thereby.

The invention further contemplates the use of coupled planar transmission lines for high-frequency.

According to a very advantageous refinement of the invention, the coupling between the signal lines is increased to significantly separate the field caused by the even mode from the field caused by the odd mode and hence, to enable an improved selectable attenuation of the more accurately localized even mode. This enhanced coupling between the signal lines is preferably achieved by accordingly adapting the geometric conductor cross sections of the symmetrically operated lines, in particular by extending the conductor surface of each line that is in essential opposite to the conductor surface of the respective other line.

For providing the field hindering or affecting material, according to preferred embodiments of the invention it is proposed to use at least one resistive layer, such as by means of low-conductivity materials for example, for the ground in three-wire systems.

Moreover in addition or as an alternative, it is suggested to provide within a disposition of a multi-layer dielectric one layer with a high-loss dielectric, wherein the loss may be dielectric and/or magnetic.

Additionally or alternatively, it is further suggested to incorporate the high- frequency lines within a multi-layer structure, wherein one layer made from a low-conductivity or resistive material is positioned between the lines and the ground line or wherein the plane of the lines is positioned between that one layer and the ground line. In particular in the latter case the one layer made from the resistive material may be separated from the plane of the lines by a dielectric above.

Subsequently, the invention is described in more detail based on preferred embodiments and with regard to the appended drawings.

### Brief Description of the Drawings

- Fig. 1a: shows a cross-sectional geometry of generally coupled lines with optimized conductor geometry for the lines and with a lossy dielectric,
- Fig. 1b: shows the cross-sectional geometry of generally coupled lines with optimized conductor geometry for the lines but with a resistive intermediate layer made from low-conductivity material,
- Fig. 2: shows symmetrically coupled planar transmission lines on a multi-layer substrate and with optimized conductor geometry for the lines,
- Fig. 3a: shows the field of an odd mode of coupled planar transmission lines on a multi-layer substrate,
- Fig. 3b: shows the field of an even mode of coupled planar transmission lines on a multi-layer substrate,
- Fig. 4a: shows a symmetrically coupled planar transmission lines in a multi-layer structure with an additional layer for attenuating the even mode between the signal lines and the ground line,
- Fig. 4b: shows the symmetrically coupled planar transmission lines in a multi-layer structure but with an additional layer for attenuating the even mode above the two signal lines, and
- Fig. 5: shows the attenuation of coupled planar transmission lines conforming to Fig. 3a and 3b with resistive ground metallization for the even and odd modes.

### Detailed Description of the invention

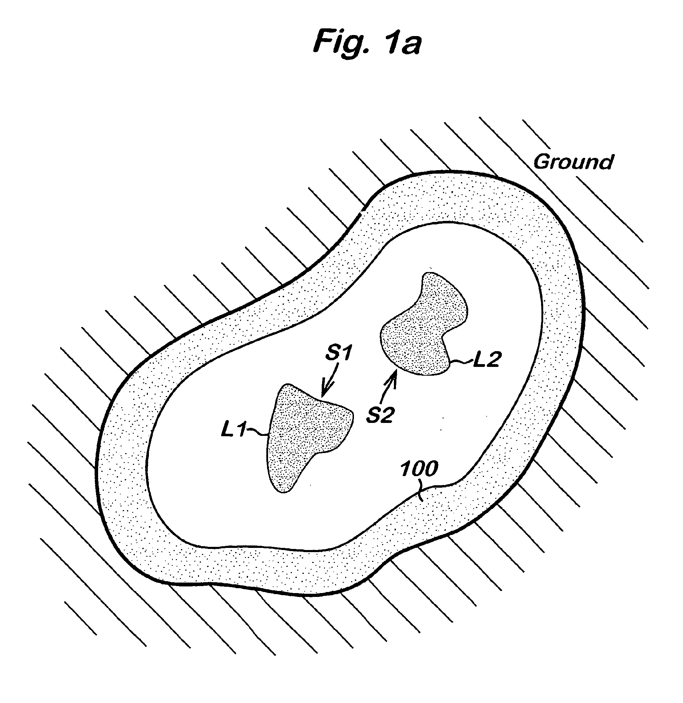

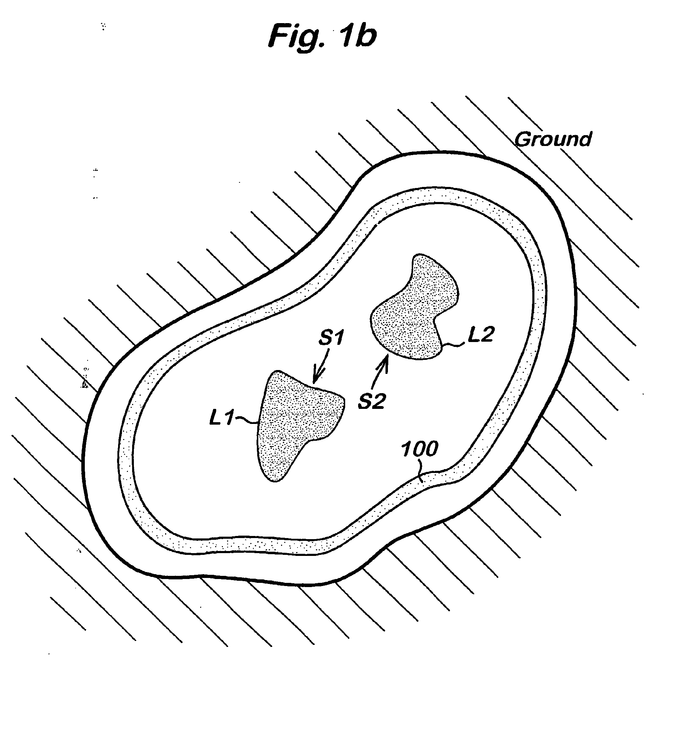

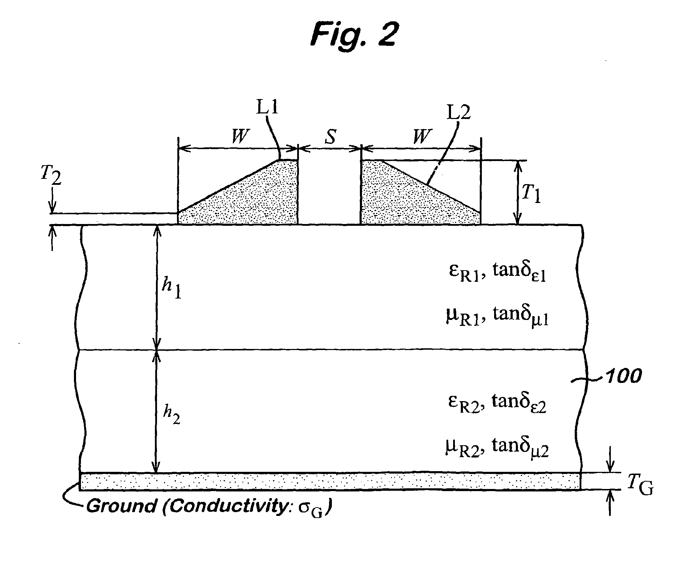

In particular in digital transmission systems coupled lines L1 and L2, of which a generalized form is schematically depicted by Fig. 1a and Fig. 1b and a cross-section of an exemplar form of coupled planar transmission lines L1 and L2 is schematically depicted by Fig. 2, are often used in symmetrical operation condition causing the odd mode, i.e. the lines L1 and L2 possess potentials of the same magnitude with respect to Ground but with opposing signs. Based thereon, for the data transmission in one direction two signals have to be generated with a 180° phase difference and hence, for data transmission at least two conductors are necessary.

Although an even mode signal wave transmitted on the symmetrically operated line is not detected at the receiver, an asymmetry after a reflection of the even mode signal wave at the receiver for example, may convert this wave signal into an odd mode wave, which then interferes with the desired odd mode wave which transmits the desired signal and may lead, in particular in the case of transmission of digital signals, to inter-symbol interference resulting in a reduced eye-opening.

Furthermore, multiple reflections caused for example by irregularities on the line L1, L2 and/or an asymmetrical line layout arise for example from curves in the lines L1 and L2 which result in different geometrical line lengths usually result in an unavoidable coupling of the two modes. For frequencies in the microwave range up to 100 GHz, the wavelength on commonly used substrates is approximately 1 mm to 6 mm. Therefore by the use of transmission lines L1 and L2 at high-frequency or even radio-frequency even a small length difference between the two lines L1 and L2 will cause a large phase difference Δϕ.

For attenuating the even mode wave according to the invention, the Ground of a three- wire system is preferably comprising a material of low conductivity a field hindering or affecting source.

In the odd mode, due to the potentials of the line L1 and L2 having the same magnitude with respect to Ground but with opposing signs, the return current is flowing largely via the second signal line, for example line L2. This will be barely affected by the increased resistance in the Ground. In contrast however, for an even mode, the return current has to flow completely via the Ground, which will mean in this case that there will be increased loss and increased attenuation of this mode.

In particular for multi-layer dielectrics, such as depicted in Fig. 1a and/or Fig. 2 for example, the attenuation of the even mode can be increased by using a dielectric medium with low dielectric and/or magnetic losses tanδ_{ε1} and tanδ_{µ1}, respectively, for the upper substrate layers, i.e. the layers which are adjacent to the signal lines L1 and L2 and a field affecting material 100 with high dielectric and/or magnetic losses tanδ_{ε2} and tanδ_{µ2}, respectively for the lower layers.

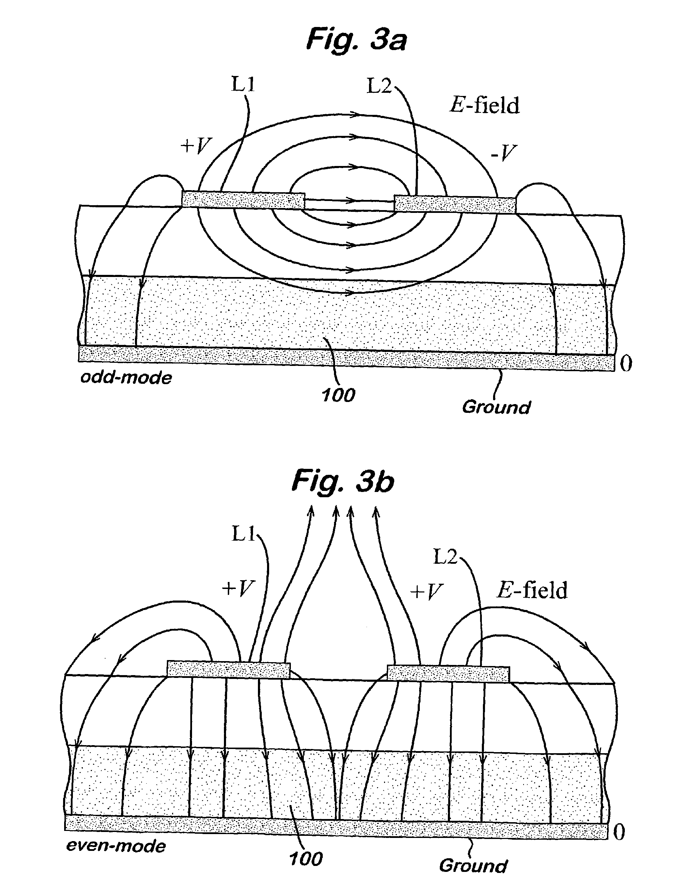

As can be seen in Figure 3a showing an exemplar odd mode of coupled planar transmission lines L1 and L2 on a multi-layer substrate, in the odd mode the largest proportion of the electromagnetic field caused by such odd mode is transmitted only in the upper substrate layers between the two lines L1 and L2, while the electromagnetic field related to an even mode, as exemplary depicted in Figure 3b, also travels through the attenuating material layer 100.

Moreover, preferred embodiments of the invention provide an improved separation of the field caused by the even mode from the field caused by the odd mode for enabling an improved selectable attenuation of the more accurately localized even mode. Especially based on the phenomena, that the proportion of the field carried in lower layers in the odd mode depends on the strength of the coupling between the two lines L1 and L2, by means of a specially optimized geometry of the line cross sections, the proportion of the field caused by an odd mode and carried in the lower layer is decreased.

Such optimized geometry of the line cross sections are exemplary depicted in Fig. 1a, 1b and 2.

As can be seen in Fig. 1a and 1b, the conductor surfaces S1 and S2 of line L1 or L2, i.e. the conductor surface section of each line that is in essential opposite to a conductor surface section of the respective other line, is extended for providing an increased coupling area between the two lines L1 and L2.

According to the exemplary optimized shape of lines L1 and L2 of Fig. 2, for a given cross-sectional area of the high-frequency lines L1 and L2 an increase in the strength of the coupling between the two lines L1 and L2 is achieved across the parallel respective "inner" or opposite line walls having an extended height *T*₁ in comparison to the respective "outer" line walls having an reduced height *T*₂.

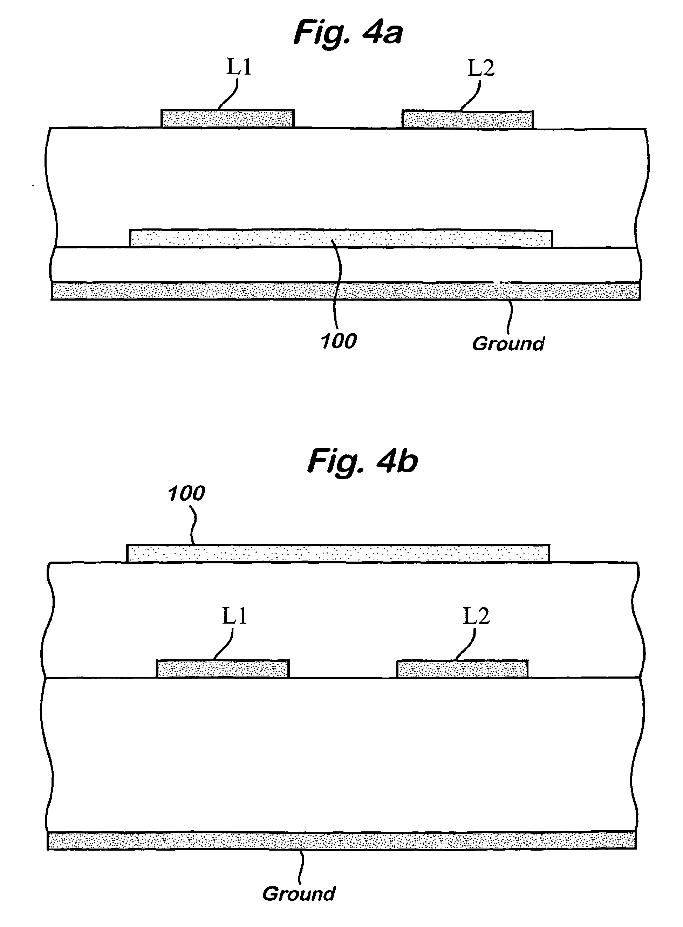

According to a further inventive approach, a specific attenuation of the even mode is also possible by applying an additional resistive or low-conductivity layer 100 within a multi-layer structure incorporating the signal transmission lines L1 and L2. Such dispositions are employed in the embodiments according to Fig. 1b, 4a and 4b. Such an additional resistive or low-conductivity layer 100 can either be inserted between the layer comprising the lines L1 and L2 and the layer comprising the Ground, as schematically depicted in Fig. 1b and Fig. 4a, the latter of which uses coupled planar transmission lines L1 and L2, or above the layer comprising the lines L1 and L2, as depicted in Fig. 4b based on planar L1 and L2, such as coupled strip transmission lines for example.

These two variants are particularly advantageous when, for example in a single substrate, other line structures, which do not allow an increased attenuation in the Ground , are also to be created in addition to the coupled lines L1 and L2. Additionally, for providing the distance necessary to selectively suppress the even mode, the one layer 100 made from the resistive field hindering material even may be separated from the plane of the lines L1 and L2 by a dielectric.

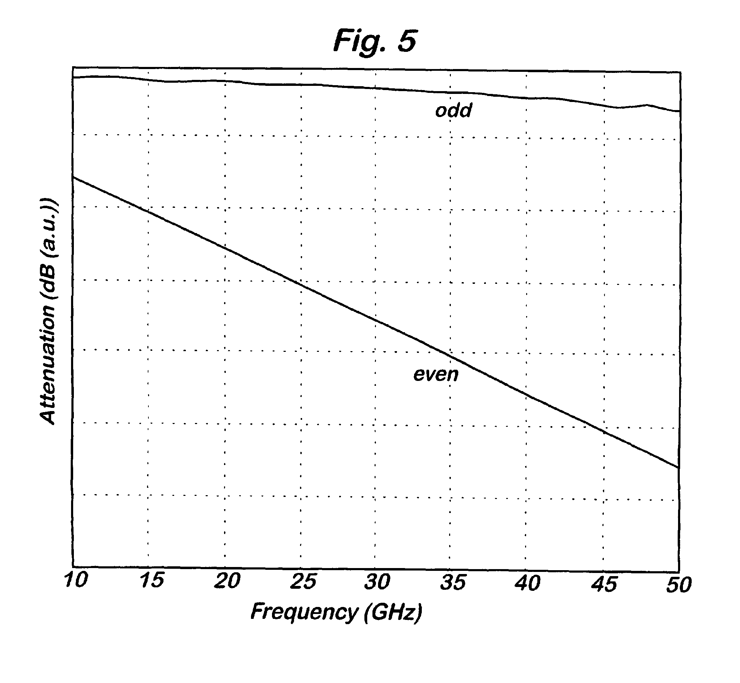

The diagram in Figure 5 shows the effect of an inventive attenuation for the coupled planar transmission lines for the even mode and the odd mode when a resistive metallization of the Ground and an attenuating substrate layer are used.

It is mentioned, that each of the approaches and/or refinements described above can be used alone but also can be combined with another as desired or necessary, for example depending on respective system constraints or requirements.

## Claims

1. Method for suppressing disturbances during transmission on symmetrically operated high-frequency lines (L1, L2) comprising the step of
- identifying an area which is influenced mainly by the magnetic and/or electric field associated with an even mode and
- providing within said area a field jamming source (100), in particular a source hindering or affecting said field, for the selective attenuation of the even mode, and the field jamming source being a homogeneous layer that is positioned between the lines (L1, L2) and ground or that represents the ground layer.

2. Method of claim 1, further comprising the step of providing an increased coupling of the lines, in particular by adapting the geometric cross sections of the symmetrically operated lines (L1, L2).

3. Method of claim 1 or 2, further **characterized by** at least one of the following steps:
- utilizing at least one resistive layer (100) for the ground line,
- utilizing a multi-layer dielectric with a high-loss dielectric (100) inserted in one layer,
- utilizing a multi-layer structure, with one layer (100) is made from a low-conductivity or resistive material and is positioned between the lines (L1, L2) and a ground,
- utilizing a multi-layer structure with the plane of the lines (L1, L2) positioned between one layer made from a resistive material and a ground, and/or
- utilizing coupled planar transmission lines (L1, L2) for the high-frequency lines (L1, L2).

4. Disposition comprising at least two ground balanced lines (L1, L2) adapted to be used for a symmetrical high-frequency operation, **characterized by** a field jamming material (100), in particular a material hindering or affecting a magnetic and/or electric field, within an area which is influenced mainly by the magnetic and/or electric field associated with the even mode, and the field jamming material being a homogeneous layer that is positioned between the lines (L1, L2) and ground or that represents the ground layer.

5. Disposition of claim 4, further **characterized by** at least one resistive layer, in particular by means of a low-conductivity material (100), for the ground.

6. Disposition of any of claims 4 to 5, further **characterized by** a multi-layer dielectric, whereby at least one layer (100) spaced apart to the lines (L1, L2) comprises a dielectric having a higher loss than a dielectric adjacent to the lines (L1, L2).

7. Disposition of claim 6, wherein the loss of the dielectric is magnetic and/or dielectric.

8. Disposition of any of claims 4 to 7, further **characterized by** a multi-layer structure, whereby at least one layer (100) spaced apart to the lines (L1, L2) comprises a material having a lower conductivity than the material adjacent to the lines (L1, L2).

9. Disposition of any of claims 4 to 8, further **characterized by** a multi-layer structure, whereby one layer (100) is made from a low-conductivity material, and this layer (100) is positioned between the lines (L1, L2) and the ground or whereby the plane of the lines (L1, L2) is positioned between one layer (100), made from a resistive material and the ground.

10. Disposition of any of claims 4 to 9, further **characterized by** lines (L1, L2) being coupled planar transmission lines (L1, L1).

## Patentansprüche

1. Verfahren zur Unterdrückung von Störungen während der Übertragung auf symmetrisch betriebenen Hochfrequenzleitungen (L1, L2), welches die folgenden Schritte umfasst:
- Identifizieren eines Bereichs, welcher hauptsächlich von dem mit einem Gleichtaktmodus assoziierten magnetischen und/oder elektrischen Feld beeinflusst wird, und
- Bereitstellen innerhalb des besagten Bereichs einer Feldstörungsquelle (100), insbesondere einer Quelle, welche das besagte Feld hindert oder beeinträchtigt, zur selektiven Dämpfung des Gleichtaktmodus, wobei die Feldstörungsquelle eine homogene Schicht ist, welche zwischen den Leitungen (L1, L2) und der Masseschicht angeordnet ist oder die Masseschicht darstellt.

2. Verfahren nach Anspruch 1, welches weiterhin den Schritt des Bereitstellens einer erhöhten Kopplung der Leitungen, insbesondere durch Anpassen der geometrischen Querschnitte der symmetrisch betriebenen Leistungen (L1, L2), umfasst.

3. Verfahren nach Anspruch 1 oder 2, weiterhin durch mindestens einen der folgenden Schritte **gekennzeichnet**:
- Verwenden von mindestens einer Widerstandsschicht (100) für die Masseleitung,
- Verwenden eines mehrlagigen Dielektrikums mit einem in einer Schicht eingefügten Dielektrikum mit hohem Verlust (100),
- Verwenden einer mehrlagigen Struktur, wobei eine Schicht (100) aus einem Material mit niedriger Leitfähigkeit oder aus einem Widerstandsmaterial besteht und zwischen den Leitungen (L1, L2) und einer Masse angeordnet ist,
- Verwenden einer mehrlagigen Struktur, wobei die Ebene der Leitungen (L1, L2) zwischen einer Schicht aus einem Widerstandsmaterial und einer Masse angeordnet ist, und/oder
- Verwenden von gekoppelten ebenen Übertragungsleitungen (L1, L2) für die Hochfrequenz-Leitungen (L1, L2).

4. Anordnung, welche mindestens zwei erdsymmetrische Leitungen (L1, L2) umfasst, welche für die Verwendung in einer symmetrischen Hochfrequenz-Operation ausgelegt ist und durch ein Feldstörungsmaterial (100), insbesondere ein Material, welches ein magnetisches und/oder elektrisches Feld hindert oder beeinträchtigt, innerhalb einer Zone, welche hauptsächlich durch das mit dem Gleichtaktmodus assoziierte magnetische und/oder elektrische Feld beeinflusst wird, **gekennzeichnet** sind, wobei das Feldstörungsmaterial eine homogene Schicht ist, welche zwischen den Leitungen (L1, L2) und der Masse angeordnet ist oder die Masseschicht darstellt.

5. Anordnung nach Anspruch 4, weiterhin **gekennzeichnet durch** mindestens eine Widerstandsschicht, insbesondere **durch** die Verwendung eines Materials mit niedriger Leitfähigkeit (100) für die Masse.

6. Anordnung nach einem beliebigen der Ansprüche 4 bis 5, weiterhin **gekennzeichnet durch** ein mehrlagiges Dielektrikum, wobei mindestens eine von den Leitungen (L1, L2) entfernte Schicht (100) ein Dielektrikum mit einem höheren Verlust als ein an die Leitungen (L1, L2) angrenzendes Dielektrikum enthält.

7. Anordnung nach Anspruch 6, wobei der Verlust des Dielektrikums magnetisch und/oder dielektrisch ist.

8. Anordnung nach einem beliebigen der Ansprüche 4 bis 7, weiterhin **gekennzeichnet durch** eine mehrlagige Struktur, wobei mindestens eine von den Leitungen (L1, L2) entfernte Schicht (100) ein Material mit einer niedrigeren Leitfähigkeit als das an die Leitungen (L1, L2) angrenzende Material enthält.

9. Anordnung nach einem beliebigen der Ansprüche 4 bis 8, weiterhin **gekennzeichnet durch** eine mehrlagige Struktur, wobei eine Schicht (100) aus einem Material mit niedriger Leitfähigkeit besteht und diese Schicht (100) zwischen den Leitungen (L1, L2) und der Masse angeordnet ist, oder wobei die Ebene der Leitungen (L1, L2) zwischen einer Schicht (100) aus einem Widerstandsmaterial und der Masse angeordnet ist.

10. Anordnung nach einem beliebigen der Ansprüche 4 bis 9, weiterhin **dadurch gekennzeichnet, dass** die Leitungen (L1, L2) gekoppelte ebene Übertragungsleitungen (L1, L2) sind.

## Revendications

1. Procédé de suppression des perturbations pendant la transmission sur des lignes à haute fréquence (L1, L2) à fonctionnement symétrique comprenant les étapes suivantes :
- identification d'une zone qui est influencée principalement par le champ magnétique et/ou électrique associé à un mode régulier et
- réalisation dans ladite zone d'une source de brouillage du champ (100), notamment une source qui empêche ou qui affecte ledit champ, pour l'atténuation sélective du mode régulier, et la source de brouillage du champ étant une couche homogène qui est placée entre les lignes (L1, L2) et la masse ou qui représente la couche de masse.

2. Procédé selon la revendication 1, comprenant en plus l'étape de réalisation d'un couplage accru des lignes, notamment en adaptant les sections transversales géométriques des lignes (L1, L2) à fonctionnement symétrique.

3. Procédé selon la revendication 1 ou 2, **caractérisé en** plus par au moins l'une des étapes suivantes :
- utilisation d'au moins une couche résistive (100) pour la ligne de masse ;
- utilisation d'un diélectrique multicouche avec un diélectrique à fortes pertes (100) inséré dans une couche ;
- utilisation d'une structure multicouche avec une couche (100) constituée d'un matériau à faible conductivité ou résistif et disposée entre les lignes (L1, L2) et une masse ;
- utilisation d'une structure multicouche avec le plan des lignes (L1, L2) placé entre une couche constituée d'un matériau résistif et une masse et/ou
- utilisation de lignes de transmission planes couplées (L1, L2) pour les lignes à haute fréquence (L1, L2).

4. Arrangement comprenant au moins deux lignes (L1, L2) symétriques par rapport à la masse conçues pour être utilisées pour un fonctionnement symétrique à haute fréquence, **caractérisé par** un matériau de brouillage de champ (100), notamment un matériau qui empêche ou qui affecte un champ magnétique et/ou électrique, au sein d'une zone qui est influencée principalement par le champ magnétique et/ou électrique associé au mode régulier, et le matériau de brouillage du champ étant une couche homogène qui est placée entre les lignes (L1, L2) et la masse ou qui représente la couche de masse.

5. Arrangement selon la revendication 4, **caractérisé en** plus par au moins une couche résistive, notamment par des moyens constitués d'un matériau à faible conductivité (100), pour la masse.

6. Arrangement selon l'une quelconque des revendications 4 à 5, **caractérisé en** plus par un diélectrique multicouche, l'au moins une couche (100) espacée des lignes (L1, L2) comprenant un diélectrique ayant une perte supérieure à celle d'un diélectrique voisin des lignes (L1, L2).

7. Arrangement selon la revendication 6, la perte du diélectrique étant magnétique et/ou diélectrique.

8. Arrangement selon l'une quelconque des revendications 4 à 7, **caractérisé en** plus par une structure multicouche, au moins une couche (100) espacée des lignes (L1, L2) comprenant un matériau ayant une conductivité inférieure à celle du matériau voisin des lignes (L1, L2).

9. Arrangement selon l'une quelconque des revendications 4 à 8, **caractérisé en** plus par une structure multicouche, une couche (100) étant constituée d'un matériau à faible conductivité et cette couche (100) étant placée entre les lignes (L1, L2) et la masse ou le plan des lignes (L1, L2) étant placé entre une couche (100) constituée de matériau résistif et la masse.

10. Arrangement selon l'une quelconque des revendications 4 à 9, **caractérisé en** plus en ce que les lignes (L1, L2) sont des lignes de transmission planes couplées (L1, L2).
